# EUROPEAN PATENT APPLICATION

(11) **EP 2 680 314 A1**
(43) Date of publication of application: **01.01.2014**
(21) Application number: 13173732.2
(22) Date of filing: 26.06.2013
(51) Int. Cl.: H01L 31/0236

(54) **Texturing of monocrystalline semiconductor substrates to reduce incident light reflectance**

(30) Priority: 27.06.2012 US 201213535224
(71) Applicant: Rohm and Haas Electronic Materials LLC, Marlborough, MA 01752 (US)
(72) Inventor: Barr, Robert K, Shrewsbury, MA 01545 (US); O'Connor, Corey, Worcester, MA 01605 (US); Hinkley, Peter W., Whitman, MA 02382 (US); Allardyce, George R., Hinckley, Leicestershire LE10 2GD (GB)
(74) Representative: Buckley, Guy Julian

(57) **Abstract**

Monocrystalline semiconductor substrates are textured with alkaline solutions to form pyramid structures on their surfaces to reduce incident light reflectance and improve light absorption of the wafers. The alkaline baths include compounds which inhibit the formation of flat areas between pyramid structures to improve the light adsorption.

## Description

### Field of the Invention

The present invention is directed to a method of texturing monocrystalline semiconductor substrates to reduce incident light reflectance. More specifically, the present invention is directed to a method of texturing monocrystalline semiconductor substrates in alkaline baths to reduce incident light reflectance by reducing flat areas between pyramid structures.

### Background of the Invention

A textured semiconductor surface reduces reflection across wide bands of incident light thereby increasing absorbed light intensity. Such semiconductors may be used in the manufacture of solar cells. Solar cells are devices that convert light energy incident on their surfaces such as sunlight into electric energy. Reducing the reflectance of light incident on the surface improves conversion efficiency into electric energy. Texturing, however, is not restricted to semiconductors in the manufacture of solar cells but also may be used in the manufacture of photovoltaic devices in general, optical and electrochemical detectors/sensors, biodetectors/biosensors, catalysts, electrodes, and other devices where reducing the reflectance of incident light improves the efficiency of the device.

Known techniques for wet chemical pyramidal (tetragonal) structure texturing of (100)-orientated silicon surfaces use alkaline media, such as solutions of alkali hydroxides, alkali carbonates, ammonia or choline. Alkali hydroxides by themselves produce unevenly textured surfaces which result in areas of high reflectivity. An additive is necessary to control the texturing rate and to form repeatable pyramid structures. Solutions of hydrazine or ethylene diamine or pyrocatechol can also be used but they are disadvantageous on account of their toxicity to workers. The most common formulations include water, sodium or potassium hydroxide and alcohol. The alcohol component used is either ethylene glycol or isopropanol.

Another problem associated with the formation of pyramid structures is when too much oxygen is concentrated in the texturing bath prior to and during texturing. The oxygen reacts with hydrogen terminated sites on the silicon causing isotropic etching which results in flat areas between the pyramid structures on the surface of the silicon causing increased incident light reflectance. To address the problem nitrogen sparging is commonly used to reduce the oxygen content of the bath; however, such sparging does not reduce the oxygen to sufficiently low levels and flat areas are typically still observed. Typically nitrogen sparging reduces oxygen content to only around 1,800ppb. Accordingly, there is still a need for a method of reducing oxygen in texturing solutions for monocrystalline silicon semiconductor wafers to improve incident light absorption.

### Summary of the Invention

In one aspect a method includes providing a monocrystalline semiconductor substrate; providing a solution including one or more alkoxylated glycols comprising a molecular weight of 170 g/mole or greater and a flash point of 75° C or greater, one or more alkaline compounds and one or more oxygen scavengers in sufficient amounts to reduce oxygen concentration in the solution to 1000ppb or less; and contacting the monocrystalline semiconductor substrate with the solution to anisotropically texture the monocrystalline semiconductor substrate.

In another aspect a texturing solution includes one or more alkoxylated glycols having a weight average molecular weight of 170 g/mole or greater and a flash point of 75° C or greater, one or more alkaline compounds, one or more oxygen scavengers in sufficient amounts to provide an oxygen concentration of 1000ppb or less and water.

The method and texturing solution are used to anisotropically texture monocrystalline semiconductors for photovoltaic devices, including semiconductors in the manufacture of solar cells. The addition of oxygen scavengers in amounts to reduce the oxygen content of the solution to 1000ppb or less inhibits or reduces formation of flat areas between pyramid structures on the textured monocrystalline semiconductors to increase incident light absorption and improve the efficiency of the devices.

### Brief Description of the Drawings

Figure 1 is a 5000X SEM taken at a 30° angle of a monocrystalline semiconductor wafer textured in an alkaline bath without an oxygen scavenger and containing 3.3ppm of oxygen.
Figure 2 is a 5000X SEM taken at a 30° angle of a monocrystalline semiconductor wafer textured in an alkaline bath containing an oxygen scavenger with an oxygen level of 0ppm

### Detailed Description of the Invention

As used throughout this specification, the terms "depositing" and "plating" are used interchangeably. The terms "current tracks" and "current lines" are used interchangeably. The terms "solution" and "bath" are used interchangeably. The indefinite articles "a" and "an" are intended to include both the singular and the plural. The term "selectively depositing" means that deposition occurs at specific desired areas on a substrate. The term "flash point" means the lowest temperature at which the vapor of a combustible liquid can be ignited in air. The unit "dynes" is a centimeter-grams-second unit of force.

The following abbreviations have the following meanings unless the context clearly indicates otherwise: °C = degrees Celsius; g = grams; L = liter; bv = by volume; A = amperes; m = meters; dm = decimeter; cm = centimeter; µm = microns; nm = nanometers; min. = minutes; ppm = part per million; ppb = parts per billion; SEM = scanning electron micrograph; UV = ultraviolet; and IR = infrared. All percentages and ratios are by weight unless otherwise indicated. All ranges are inclusive and combinable in any order except where it is logical that such numerical ranges are constrained to add up to 100%.

Solutions for texturing semiconductor substrates include one or more alkoxylated glycols having a weight average molecular weight of 170 g/mole or greater and a flash point of 75° C or greater, and one or more alkaline compounds. Typically, the weight average molecular weight of the alkoxylated glycols range from 170 g/mole to 4000 g/mole, more typically from 190 g/mole to 500 g/mole. Flash points typically range from 75° C to 300° C or such as from 100° C to 300° C. More typically, flash points range from 140° C to 200° C. Alkoxylated glycols used in the texturing solutions are either water-soluble or at least water-miscible. The solutions provide uniform texturing as well as reproducibility of pyramid structure formation on semiconductors. This results in reduced incident light reflectance and improved conversion efficiency of incident light into electric energy. The flash points of 75°C or greater provide nonvolatile texturing solutions preventing substantial evaporation of solution components. In addition, the alkoxylated glycols have boiling points of 190° C or greater which further reduces the amount lost at operating temperatures. Accordingly, the texturing solutions may be used over longer periods of time than many conventional texturing solutions. This reduces downtime for manufacturing processes and reduces the frequency of solution replacement, thus improving the overall efficiency of the texturing method. This improved efficiency of the method reduces costs to both consumers and manufactures alike.

Alkoxylated glycols are included in the solution in amounts of 0.001wt% to 2wt% of the solution. Typically, the alkoxylated glycols are included in amounts of 0.1wt% to 1wt% of the solution. The alkoxylated glycols are non-cyclic but are linear or branched compounds. Alkoxylated glycols include, but are not limited to, compounds having a general formula:

HO(CₓH₂ₓO)ₘH (I)

wherein m is an integer of 3 or greater, or such as from 8 to 66. Typically, m is an integer of 3 to 6, more typically from 3 to 5 and x is an integer of 3 to 6, or such as from 3 to 4. Examples of such alkoxylated glycols are tripropylene glycol, tetrapropylene glycol, polypropylene glycol, tributylene glycol, tetrabutylene glycol, polybutylene glycol, tripentylene glycol, tetrapentylene glycol and polypentylene glycol.

Alkoxylated glycols also include, but are not limited to, compounds having a general formula:

HO(CH₂CH₂O)ₙH (II)

wherein n is an integer of 3 or greater, or such as from 5 to 200. Typically, n is an integer of 3 to 5, more typically from 3 to 4. Examples of such alkoxylated glycols are triethylene glycol, tetraethylene glycol and polyethylene glycol.

The texturing solutions also include one or more alkaline compounds. Such alkaline compounds include, but are not limited to, alkali metal hydroxides, such as potassium, sodium hydroxide and lithium hydroxide, and quaternary ammonium hydroxides, such as tetramethyl ammonium hydroxide, tetrapropyl ammonium hydroxide, tetrabutyl ammonium hydroxide, tetramethyl-2-hydroxylethyl ammonium hydroxide (choline), trimethyl-3-hydroxypropyl ammonium hydroxide, trimethyl-3-hydroxybutyl ammonium hydroxide, trimethyl-4-hydroxybutyl ammonium hydroxide, tritriethyl-2-hydroxylethyl ammonium hydroxide, tripropyl-2-hydroxyethyl ammonium hydroxide, tributyl-2-hydroxylethyl ammonium hydroxide, dimethylethyl-2-hydroxyethyl ammonium hydroxide, dimethyldi(2-hydroxyethyl ammonium hydroxide, monomethyltri(2-hydroxyethyl) ammonium hydroxide, monomethyltriethyl ammonium hydroxide, monomethyltripropyl ammonium hydroxide, monomethyltributyl ammonium hydroxide, monoethyltrimethyl ammonium hydroxide, monoethyltributyl ammonium hydroxide, dimethyldiethyl ammonium hydroxide and dimethyldibutyl ammonium hydroxide.

Other alkaline components include ammonium hydroxide, alkanolamines such as 2-aminoethanol (monoethanolamine), 1-amino-2-propanol, 1-amino-3-propanol, 2-(2-amino-ethoxy)ethanol, 2-(2-aminoethylamino)ethanol. Other suitable alkaline compounds include 3-methoxypropylamine, morpholine, alkane diamines, such as 1,3-pentanedaimine and 2-methyl-1,5-pentanediamine, and guanidine.

Preferably the alkaline compound included in the texturing solution is chosen from one or more hydroxides. More preferably, the alkaline compound is chosen from one or more alkali metal hydroxides, such as sodium and potassium hydroxides. Alkaline compounds are included in the texturing solutions in amounts of 0.5wt% to 15wt% of the solution. Preferably, the alkaline compound is included in the texturing solution in amounts of 1wt% to 10wt%.

Optionally, the texturing solution may include one or more alkali metal chlorides, such as sodium and potassium chloride and one or more silicates, such as alkali metal silicates, such as the sodium and potassium silicates. Mixture of metal chlorides and metal silicates may be used. Such metal chlorides and metal silicates may be included in the solutions in amounts of 0.01wt% to 2wt%, or such as from 0.5wt% to 1wt% of the solution.

Oxygen scavengers are included in the texturing solutions in sufficient amounts to maintain oxygen content of the solution at 1000ppb or less. Preferably the oxygen content of the texturing solution during texturing is 1000ppb to 0ppb, more preferably the oxygen content of the solution is 500ppb to 0ppb. Most preferably the oxygen content is from 200ppb to 0ppb. While not being bound by theory, it is believed that the reduced oxygen content inhibits or prevents formation of flat areas between pyramid structures on the surface of a monocrystalline semiconductor by inhibiting isotropic etching. The flat area increases incident light reflectance and reduces the efficiency of the monocrystalline semiconductor.

Oxygen scavengers include, but are not limited to, hydroxyl amine compounds having a formula: 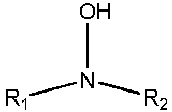 wherein R₁ and R₂ may be the same or different and are hydrogen, substituted or unsubstituted (C₁-C₁₀)alkyl, substituted or unsubstituted (C₅-C₁₀)cycloalkyl or substituted or unsubstituted (C₆-C₁₀)aryl, with the proviso that R₁ and R₂ are not hydrogen at the same time. Examples of such alkyl groups are methyl, ethyl, propyl, isopropyl, hydroxymethyl, 2-hydroxyethyl, pentyl, t-butyl and octyl. Examples of cycloalkyl groups are cyclopentyl, cyclophexyl, 4-methylcyclohexyl and cyclooctyl. Examples of aryl groups are phenyl, naphthayl, xylyl, 4-hydroxyphenyl and tolyl. Preferred compounds include N-methylhydroxylamine, N-isopropylhydroxylamine, N-cyclohexylhydroxylamine and N,N-diethylhydroxylamine.

Oxygen scavenges also include, but are not limited to, organic acids such as aliphatic, aromatic and amino carboxylic acids and salts thereof. Examples of carboxylic acids are acetic acid, propionic acid, butyric acid, pentanoic acid, 3-methylbutanoic acid, gallic acid, citric acid, lactic acid, ascorbic acid, tartronic acid and 2,4-dihydroxybenzoic acid. Examples of amino carboxylic acids are glycine, dihydroxy ethyl glycine, alanine, valine, leucine, asparagines, glutamine and lysine.

Additional oxygen scavengers include hydrazine, carbohydrazide, erythorbate, methylethylketoxime, hydroquinone, hydroquinone sulfonate, sodium salt, ethoxyquin, methyltetrazone, tetramethylphenylenediamine, DEAE 2-ketogluconate and hydroxyacetone. Preferred compounds are hydroquinone and hydroquinone sulfonate, sodium salt.

In general, oxygen scavengers are included in the solutions in amounts of 0.001wt% to 1wt%. Preferably the oxygen scavengers are included in the solutions in amounts of 0.005wt% to 0.1wt% to provide the desired oxygen content of the solution.

In addition to water, the texturing solutions can optionally include one or more organic solvent. Such solvents include aliphatic, alicyclic, aralkyl glycols and cyclic amines. Examples of glycols are ethylene glycol, propylene glycol, 1,3-propanediol, 2,4-dimethyl-2-ethyl-hexane-1,3-diol, 2,2-dimethyl-1,3-propanediol, 2-ethyl-2-butyl-1,3-propanediol, 2-ethyl-2-isobutyl-1,3-propane-diol, 1,3-butanediol, 1,4-butanediol, 1,5-pentanediol, 1,6-hexanediol, 2,2,4-trimethyl-1,6-hexanediol, 1,2-cyclohexanedimethanol, 1,3-cyclohexanedimethanol, 1,4-cyclohexanedimeethanol, 2,2,4,4-tetramethyl-1,3-cyclobutanediol, and p-xylylenediol. Examples of cyclic amines are piperrazine-based compounds, morpholine-based compounds, pyridine-based compounds, piperidine-based compounds, piperidone-based compounds, pyrrolidine-based compounds, pyrrolidone-based compounds and imidazoline-based compounds. Such compounds are included in the solutions in sufficient amounts to solubilize all of the components. Typically such organic solvents are included in amounts of 0.1wt% to 5wt%. Preferably solvents which have a flash point of 75° C or greater is used. Such preferred solvents include, but are not limited to, neopentyl glycol, glycerol, butyl carbitol, 1,5-pentanediol, 1,6-hexanediol, n-methylpyrrolidone (NMP), 1,4-butanediol, 2-pyrrolidone, 1,3-dimethyl-2-imidazolidinone, 4-(2-aminoethyl)morpho line and 1-(2-aminoethyl)piperidine.

The texturing solutions may be applied to a surface of a monocrystalline semiconductor substrate by any suitable method known in the art. The texturing solutions are applied to a surface of the semiconductor substrate at temperatures of 70° C or higher, typically from 80° C to 200° C, or such as from 90° C to 150° C. Typically, the aqueous texturing solutions are applied to a surface of the monocrystalline semiconductor substrate by horizontal or vertical processes. Such methods are well known in the art. Briefly, horizontal methods involve passing the semiconductor substrate on a conveyor system and spraying the solution on the surface of the substrate. In the vertical process the substrate is dipped in the texturing solution. Various conventional apparatus used for such processes are well known in the art.

The texturing solution is applied to a surface of the monocrystalline semiconductor substrate for dwell times of 10 min. to 30 min. The semiconductor substrate is then rinsed with water. The texturing method is anisotropic and forms uniform and repeatable pyramid (tetragonal) structures over the entire treated surface of the semiconductor substrate. The pyramid structures are randomly dispersed over the entire treated surface. The pyramid structures may range in height from 1µm to 10µm.

The monocrystalline semiconductors textured with the solution reduce reflectance from incident light applied to their textured surfaces. Reflectance of incident light in the 360nm to 1000nm wavelength range is less than 11.5%. Typically reflectance of incident light is from 10% to 11.5%. Reflectance may be measured using conventional reflectometers well known in the art. Accordingly, monocrystalline semiconductors textured by the method using the solutions are suitable for use in devices which convert incident light, such as light from sunlight, lasers, fluorescent light, as well as other sources of light, into electric energy. Such devices include, but are not limited to photovoltaic devices, such as solar cells, optical and electrochemical detectors/sensors, biodetectors/biosensors, catalysts, electrodes, gate electrodes, ohmic contacts, interconnection lines, Schottky barrier diode contacts and optoelectronic components.

Although the texturing method may be used to texture monocrystalline semiconductor substrates for various devices, typically, the texturing method is used in the manufacture of photovoltaic devices, such as solar cells. Typically the semiconductor substrate is in the form of a wafer. Such substrates typically have a p-type base doping. However, texturing may be done on semiconductor wafers prior to any doping or other processing steps. In general, texturing may be done at any convenient time during the manufacture of the photovoltaic device. Typically, the semiconductor substrate is textured before the doping process is complete.

The entire back side of the wafer may be metal coated or a portion of the back side may be metal coated, such as to form a grid. Such back side metallization may be provided by a variety of techniques, and may be done prior to the metallization of the front side of the wafer. In one embodiment, a metal coating is applied to the back side in the form of an electrically conductive paste, such as a silver-containing paste, an aluminum-containing paste or a silver and aluminum-containing paste; however, other suitable pastes known in the art also may be used. Such conductive pastes typically include conductive particles embedded in a glass matrix and an organic binder. Conductive pastes may be applied to the wafer by a variety of techniques, such as screen printing. After the paste is applied, it is fired to remove the organic binder. When a conductive paste containing aluminum is used, the aluminum partially diffuses into the back side of the wafer, or if used in a paste also containing silver, may alloy with the silver. Use of such aluminum-containing paste may improve the resistive contact and provide a "p+"-doped region. Heavily doped "p+"-type regions by previous application of aluminum or boron with subsequent interdiffusion may also be produced. Optionally, a seed layer may be deposited on the back side of the wafer and a metal coating may be deposited on the seed layer by electroless or electrolytic plating.

To produce the semiconductor junction, phosphorus diffusion or ion implantation takes place on the front side of the wafer to produce an n-doped (n+ or n++) region and provides the wafer with a PN junction. The n-doped region may be referred to as the emitter layer.

The front side or emitter layer of the wafer is subjected to anisotropic texturing in order to impart to the surface an improved light incidence geometry which reduces reflections. The solution including one or more alkoxylated glycols having a weight average molecular weight of 170 g/mole and a flash point of 75° C or greater, one or more alkaline compounds and one or more oxygen scavengers in amounts sufficient to maintain an oxygen concentration of 1000ppb or less is applied to the emitter layer for 10 min. to 30 min., typically from 10 min. to 15 min. to form uniform and randomly dispersed pyramid structures on the emitter layer. The emitter layer is substantially free of flat areas which increase incident light reflectance. The texturing solutions have surface tensions of 72 dynes/cm² or less, preferably 40 dynes/cm² or less. More preferably the surface tension is 20-40 dynes/cm². The temperature of the solution ranges from 80° C to 110° C. After a dwell time of 10 min. to 30 min., the wafer is rinsed with water to remove the texturing solution.

An anti-reflective layer is added to the front side or emitter layer of the wafer. In addition the anti-reflective layer may serve as a passivation layer. Suitable anti-reflective layers include, without limitation, silicon oxide layers such as SiOₓ, silicon nitride layers such as Si₃N₄, a combination of silicon oxide and silicon nitride layers, and combinations of a silicon oxide layer, a silicon nitride layer with a titanium oxide layer such as TiOₓ. In the foregoing formulae, x is an integer representing the number of oxygen atoms. Such anti-reflective layers may be deposited by a number of techniques, such as by various vapor deposition methods, for example, chemical vapor deposition and physical vapor deposition.

The front side of a wafer contains a metallized pattern. For example, the front side of a wafer may be composed of current collecting lines and current busbars. Current collecting lines are typically transverse to the busbars and typically have a relatively fine-structure (i.e. dimensions) relative to current busbars.

The pattern reaches through the antireflective layer to expose the surface of the semiconductor body of the wafer. Alternatively trenches may be formed in the openings to create a selective emitter. These trenches may be regions of high doping. A variety of processes may be used to form the pattern, such as, but not limited to, laser ablation, mechanical means, and lithographic processes, all of which are well known in the art. Such mechanical means include sawing and scratching. Typical photolithographic processes include disposing an imageable material on the surface of the wafer, patterning the imageable material to form openings in the anti-reflective layer, transferring the pattern to the wafer, depositing a nickel layer in the openings and removing the imageable material. In one embodiment, the imageable material is removed before the step of depositing a metal layer in the openings. In another embodiment, the imageable material is removed after the step of depositing a metal layer in the openings. When the imageable material is present during the metal deposition step, such imageable material typically avoids any dyes, such as contrast dyes, that absorb in the wavelength of radiation used during the nickel deposition step. Imageable material present during the plating step typically contains a dye which has a minimum light transmittance of 40-60%.

The imageable material may be removed using any suitable polymer remover. Such removers may be alkaline, acidic or essentially neutral and are well known in the art.

In one embodiment, the front side of the wafer may be metallized using a conductive paste, which may be the same as or different from any conductive paste used on the rear side of the wafer. Any conductive paste used to metallize the front side of a wafer typically does not contain aluminum. The temperature used in the firing of the paste depends on the particular paste used, the thickness of any antireflective layer used, among other factors. The choice of such temperature is well within the ability of those skilled in the art. Also, it is appreciated by those skilled in the art that the firing process may be performed in an oxygen-containing atmosphere, an inert atmosphere, a reducing atmosphere, or a combination of any of these. For example, the firing may be performed at a first temperature in an atmosphere containing little oxygen and then at a second temperature under an inert atmosphere or under a reducing atmosphere, where the second temperature is higher than the first temperature.

Following the firing process, the wafer may optionally be contacted with a buffered acid solution, such as a buffered hydrofluoric acid solution, to remove any oxide produced during the firing procedure. Such contact may be by spraying the solution on the wafer or by dipping the wafer into such solution or by any other suitable means.

After the front side pattern and rear side of the wafer are metallized using conductive paste, a layer of metal is then deposited on the front side conductive pattern. Such layer of metal may be any suitably conductive metal such as gold, silver or copper, and is typically silver. Such metals may be deposited by methods known in the art. In one embodiment, the deposited metal layer is composed of the same metal used in the conductive paste. For example, a silver layer is deposited on a silver-containing conductive paste.

Silver may be deposited by light induced plating (LIP) or conventional silver electroplating methods well known in the art. When LIP is used, the rear side of the semiconductor wafer is connected to a source of external current (rectifier). A silver anode placed in the silver plating composition is connected to the rectifier such that a completed circuit is formed between the components. Typical current densities are from 0.1 A/dm² to 5 A/dm². The total current requirement is dependent upon the particular size of the wafer used. Additionally, the silver anode provides a ready source of silver ions to replenish the silver plating composition with silver ions without the need to use an external source. A light source is positioned to illuminate the semiconductor wafer with light energy. The light source can be, for example, a fluorescent or LED lamp which provides energy within the wavelengths to which the semiconductor wafer is photovoltaically sensitive. A variety of other light sources may be used, such as, but not limited to, incandescent lamps such as a 75 watt and 250 watt lamps, mercury lamps, halogen lamps and a 150 watt IR lamp. Examples of commercially useful silver plating compositions are available as ENLIGHT™ Silver Plate 600 and 620 from Rohm and Haas Electronic Materials, LLC Marlborough, Massachusetts.

The plating cell is of such a material as to be chemically inert with respect to the silver plating composition and has a minimum light transmittance of 40-60%. Alternatively, the wafer can be positioned horizontally in the plating cell and illuminated from above the silver plating composition, in which case the plating cell need not have at least the minimum light transmittance.

In another embodiment a metal seed layer may be deposited on the front side conductive pattern instead of a metal paste. Typically the metal seed layer is nickel. The nickel seed layer may be deposited by any conventional nickel deposition method known in the art. Typically, the nickel seed layer is deposited by light assisted nickel deposition. If the source of the nickel is an electroless nickel composition, plating is done without application of external current. If the source of the nickel is from an electrolytic nickel composition, a rear side potential (rectifier) is applied to the semiconductor wafer substrate. The light may be continuous or pulsed. Prior to depositing nickel, surface oxides are typically removed from the conductive pattern using a solution of 1% hydrofluoric acid.

Light which may be used in the plating process includes, but is not limited to, visible light, IR, UV and X-rays. Light sources include, but are not limited to, incandescent lamps, LED lights (light emitting diodes), infrared lamps, fluorescent lamps, halogen lamps and lasers. In general the amount of light applied to the semiconductor may be 8000 lx to 20,000 lx.

Typically, nickel is deposited through the openings in the anti-reflective layer and onto the exposed textured surface of the semiconductor wafer using an electroless nickel plating composition. Examples of commercially available electroless nickel compositions include DURAPOSIT™ SMT 88 Electroless Nickel and NIPOSIT™ PM 980 and PM 988 Electroless Nickel. All are available from Rohm and Haas Electronic Materials, LLC, Marlborough, MA, U.S.A.

Alternatively, electrolytic nickel compositions may be used. When an electrolytic composition is used, an applied rear side potential (rectifier) is used in addition to light to deposit the nickel. Typical current densities are from 0.1 A/dm² to 2 A/dm². The particular current requirement is dependent upon the particular size of the wafer used. The electroplating processes used are conventional. Suitable electrolytic nickel plating baths are commercially available as well as many which are disclosed in the literature. Examples of commercially available electrolytic nickel baths are the NICKEL GLEAM™ Electrolytic Nickel products obtainable from Rohm and Haas Electronic Materials, LLC.

By illuminating the front of the semiconductor wafer with light energy, plating occurs on the front. The impinging light energy generates a current in the semiconductor. The rate of plating on the front is controllable by adjusting the light intensity, bath temperature, reducing agent activity, starting wafer conditions, doping level as well as other parameters which are known to workers in the art. If the plating bath is an electrolytic bath the rate of plating may also be adjusted by the rectifier. A nickel layer of 20nm to 300nm thickness is typically desired, with the exact thickness depending on various factors such as on the application, size, pattern and geometry.

After the nickel is deposited through the openings and adjacent to the exposed surface of the semiconductor wafer substrate, silver is then deposited adjacent to the nickel. Conventional electroplating silver compositions may be used. The silver compositions may be cyanide containing silver compositions or cyanide-free silver compositions.

Silver may deposited on the nickel by light induced plating (LIP) or conventional silver electroplating methods well known in the art. The procedure of LIP plating is similar to that for plating the silver paste described above. A silver layer of 1µm to 30µm thickness is typically desired, with the exact thickness depending on various factors such as on the application, size, pattern and geometry.

After the silver metal is deposited onto and adjacent the nickel, the semiconductor is then sintered to form nickel silicide. Sintering is done with the silver deposited onto the nickel surface to improve adhesion between the silver and nickel. The improved bonding between the nickel and the silicon reduces the probability of adhesion failure between the nickel silicide and the silver. Further, silver is not incorporated into the silicide by the sintering temperatures, thus nickel silicide is formed with the silver protecting the nickel from oxidation during sintering. A furnace providing a wafer peak temperature of 380° C to 550° C may be used. Typically, peak temperature times range from 2 seconds to 20 seconds. An example of a suitable furnace is a lamp based furnace (IR).

Since the silver layer protects the nickel from oxidation during sintering, sintering may be done in oxygen containing environments as well as inert gas atmosphere or vacuum. In general, sintering is done for 3 min. to 10 min. Line speeds at which the semiconductor passes through the furnace may vary depending on the furnace used. Minor experimentation may be done to determine the appropriate line speed. Typically, the line speed is from 330 cm/minute to 430 cm/minute.

The method and texturing solution are used to anisotropically texture monocrystalline semiconductors for photovoltaic devices, including semiconductors in the manufacture of solar cells. The addition of oxygen scavengers in amounts to reduce the oxygen content of the solution to 1000ppb or less inhibits or reduces formation of flat areas between pyramid structures on the textured monocrystalline semiconductors to increase incident light absorption and improve the efficiency of converting incident light into electrical energy.

The following examples are included to illustrate the invention but are not intended to limit its scope.

### Example 1

Three doped monocrystalline silicon wafers (obtained from SolarGiga) having n+ doped zones on the front side or emitter layer and a pn-junctions below the emitter layer were immersed in an aqueous texturing solution in an 18 liter falcon line which is a large scale texturing bath. The texturing solution had the formula disclosed in Table 1 below.

**Table 1**

| **COMPONENT** | **AMOUNT** |
|---|---|
| Tripropylene glycol¹ | 0.5wt% |
| Potassium hydroxide | 6wt% |
| 1,4-butanediol² | 0.5wt% |
| Water | 93wt% |

| | |
|---|---|
| ¹weight average molecular weight = 192 g/mole; ²Flash point = 121 ° C flash point = 140.5 ° C Boiling point = 268° C | |

Each wafer was weighed before texturing. The aqueous texturing solution was at 80° C. There was no nitrogen bubbling. The solution was hand stirred. The pH of the texturing solution was 13. During texturing the dissolved oxygen content was measured using D0202G 2-Wire Dissolved Oxygen Analyzer (available from Yokogawa Electric Corporation). The average dissolved oxygen level for each wafer over its dwell time in the texturing solution is shown in Table 2 below. The dwell time for each wafer in the texturing solution was 15 min. After 15 min. the aqueous texturing solution was rinsed with water and allowed to dry at room temperature. Each wafer was then weighed and the weight difference was tallied as shown in the table below.

The surface of the treated emitter layer was then examined for the quality of texturing. The surface was examined using a scanning electron microscope (AMRAY 1510 Filed Emission scanning electron microscope). The results are shown in Table 2 below.

Reflectance of the textured surface was also taken using a MacBeth Coloreye Reflectometer 7000 at the wavelength of 600nm. The source of the incident light was a pulsed xenon bulb. An average of 6 reflectance readings was taken across the surface of each wafer.

The average reflectance is shown in Table 2.

**Table 2**

| **Test Wafer** | **Dissolved O₂ Level (ppb)** | **% Average Reflectance** | **Reflectance Standard Deviation** | **Silicon Removed per Side (µm)** | **Overall Appearance of Emitter** |
|---|---|---|---|---|---|
| 1 | 4760 | 11.78 | 0.30 | 12.23 | Some non-uniform shiny areas |
| 2 | 4500 | 11.60 | 0.10 | 12.77 | Some non-uniform shiny areas |
| 3 | 4680 | 11.74 | 0.19 | 12.90 | Some non-uniform shiny areas |

The non-uniform and shiny areas observed on the emitter layer were indicative of undesired flat areas between pyramid structures.

### Example 2

The method described in Example 1 was repeated using three additional doped silicon monocrystalline semiconductor wafers. In addition to the components of Table 1, the aqueous texturing formulation included N-ispropylhydroxylamine. The aqueous texturing solution had the formulation shown in Table 3 below.

**Table 3**

| **COMPONENT** | **AMOUNT** |
|---|---|
| Tripropylene glycol | 0.5wt% |
| Potassium hydroxide | 6wt% |
| 1,4-butanediol | 0.5wt% |
| N-isopropylhydroxylamine³ | 0.017wt% |
| Water | 92.983wt% |

| | |
|---|---|
| ³Hydroguard™ I-15 (available from The Dow Chemical Company, Midland, MI) | |

Each wafer was weighed before texturing and after texturing. The aqueous texturing solution was at 80° C. There was no nitrogen bubbling. The solution was hand stirred. The pH of the texturing solution was 13. The results are shown in Table 4.

**Table 4**

| **Test Wafer** | **Dissolved O₂ Level (ppb)** | **% Average Reflectance** | **Reflectance Standard Deviation** | **Silicon Removed per Side (µm)** | **Overall Appearance of Emitter** |
|---|---|---|---|---|---|
| 4 | 0 | 11.31 | 0.04 | 11.61 | Completely uniform |
| 5 | 0 | 11.33 | 0.07 | 11.55 | Completely uniform |
| 6 | 0 | 11.41 | 0.01 | 11.43 | Completely uniform |

The addition of the N-isopropylhydroxylamine reduced the oxygen content of the texturing solution down to 0ppb. The reduction of the oxygen levels to zero reduced % average reflectance in comparison to the formulation in Example 1 which did not include the N-isopropylhydroxylamine. The lower standard deviation of the reflectance in this example indicated more uniform texturing than in Example 1 which had a higher reflectance standard deviation. The amount of silicon removed on each side of each wafer was less than the wafers in Example 1 which was also more favorable to pyramid structure formation than in Example 1. The emitter layer of each wafer appeared completely uniform. There were no observed flat areas between pyramid structures. Good texturing was consistent.

### Example 3

Two doped monocrystalline silicon semiconductor wafers were textured with one of the two texturing solutions shown in Table 5.

**Table5**

| **Component** | **Solution 1** | **Solution 2** |
|---|---|---|
| Tripropylene glycol | 1.2% bv | 1.2% bv |
| Potassium hydroxide | 6wt% (25 g/L) | 6wt% (25 g/L) |
| 1,4-butanediol | 0.3% bv | 0.3% bv |
| N-isopropylhydroxylamine | 0 | 0.017wt% |
| Water | Balance | Balance |

Each wafer was immersed in one of the two texturing solutions for 10 minutes. The solutions were kept at 80° C and the pH of the solutions was at 13. There was no nitrogen bubbling and the solutions were hand stirred. The oxygen content of each bath was measured at the beginning of the texturing period using D0202G 2-Wire Dissolved Oxygen Analyzer. The oxygen content of solution 1 which did not include N-isopropylhydroxylamine had an oxygen content of 3.3ppm. In contrast, solution 2 which included N-isopropylhydroxylamine had an oxygen content of 0ppm.

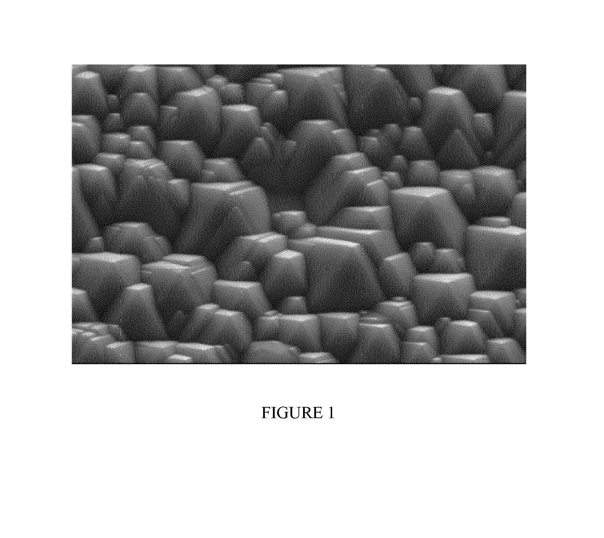

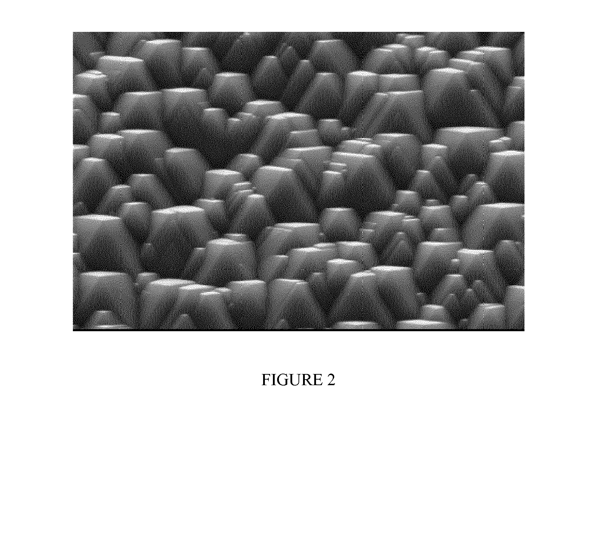

The reflectance of each wafer was measured using a MacBeth Coloreye Reflectometer 7000 at a wavelength of 600nm. The % average reflectance of the wafer textured with solution 1 was 12.1%. In contrast, the wafer textured with solution 2 had a reduced % average reflectance of 11.3%. Figure 1 is a SEM of the wafer textured with solution 1 taken with the AMRAY 1510 Filed Emission scanning electron microscope. Figure 1 shows a flat area in the center of the SEM which may have been caused by isotropic etching of the wafer due to oxygen in the solution. The tops of the pyramids appear flat because the image was taken at an angle of 30 degrees. In contrast, Figure 2 is a SEM of the wafer textured with solution 2 which included N-isopropylhydroxylamine. No flat areas were observed. The lack of flat areas indicated that only anisotropic texturing occurred on the emitter layer of the wafer. Accordingly, the wafer which was textured with solution 2 had reduced incident light reflectance in comparison to the wafer textured with solution 1.

## Claims

1. A method comprising:
a) providing a monocrystalline semiconductor substrate;
b) providing a solution comprising one or more alkoxylated glycols comprising a molecular weight of 170 g/mole or greater and a flash point of 75° C or greater, one or more alkaline compounds and one or more oxygen scavengers in sufficient amounts to reduce oxygen concentration in the solution to 1000ppb or less; and
c) contacting the monocrystalline semiconductor substrate with the solution to anisotropically texture the monocrystalline semiconductor substrate.

2. The method of claim 1, wherein the one or more oxygen scavengers are chosen from compounds having formula: 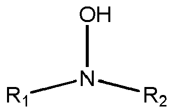 wherein R₁ and R₂ may be the same or different and are hydrogen, substituted or unsubstituted (C₁-C₁₀)alkyl, substituted or unsubstituted (C₅-C₁₀)cycloalkyl or substituted or unsubstituted (C₆-C₁₀)aryl, with the proviso that R₁ and R₂ are not hydrogen at the same time.

3. The method of claim 1, wherein the one or more oxygen scavengers are chosen from organic acids.

4. The method of claim 1, further comprising one or more organic solvents.

5. The method of claim 1, wherein a surface tension of the solution is 72 dynes/cm² or less.

6. The method of claim 1, wherein a pH or the solution is 13-14.

7. A texturing solution comprising one or more alkoxylated glycols having a weight average molecular weight of 170 g/mole or greater and a flash point of 75° C or greater, one or more alkaline compounds and one or more oxygen scavengers in sufficient amounts to provide an oxygen concentration of 1000ppb or less.

8. The texturing solution of claim 7, wherein a surface tension of the solution is 72 dynes/cm² or less.

9. The texturing solution of claim 7, further comprising one or more organic solvents.
